# EUROPEAN PATENT APPLICATION

(11) **EP 4 503 353 A1**
(43) Date of publication of application: **05.02.2025**
(21) Application number: 23189544.2
(22) Date of filing: 03.08.2023
(51) Int. Cl.: H01S 5/14, H01S 3/105, H01S 3/106, H01S 3/107

(54) **EXTERNAL CAVITY SEMICONDUCTOR LASER**

(71) Applicant: Vexlum Oy, 33710 Tampere (FI)
(72) Inventor: PENTTINEN, Jussi-Pekka, 33820 Tampere (FI); UUSITALO, Topi, 33720 Tampere (FI)
(74) Representative: WSL Patentanwälte Partnerschaft mbB

(57) **Abstract**

The present disclosure relates to a laser (1) comprising a first end mirror (5), a semiconductor gain structure (6), a polarizing element (11), an etalon (10) and a second end mirror (9), wherein the first end mirror and the second end mirror form an external cavity, wherein semiconductor gain structure, the polarizing element and the etalon are arranged in the external cavity, and wherein the polarizing element and the etalon are configured so that during the operation of the laser, the laser generates the laser radiation at a single mode. The etalon comprises an electro-optic crystal and an electrode structure (13) arranged and configured to apply an electric field to the electro-optic crystal so that an optical pathlength of the external cavity is variable in dependence upon the electric field applied to the electro-optic crystal.

## Description

The present disclosure relates to a laser comprising a first end mirror, a semiconductor gain structure, wherein during an operation of the laser the semiconductor gain structure generates and amplifies electromagnetic laser radiation, a polarizing element, an etalon, wherein the etalon comprises a first end facet and a second end facet, which first end facet and second end facet are parallel to each other, and a second end mirror, wherein the first end mirror and the second end mirror form an external cavity, wherein semiconductor gain structure, the polarizing element and the etalon are arranged in the external cavity, and wherein the polarizing element and the etalon are configured so that during the operation of the laser, the laser generates the laser radiation at a single mode.

Furthermore, the present disclosure relates to a method for generating and emitting electromagnetic laser radiation in a laser, wherein the laser comprises a first end mirror, a semiconductor gain structure, a polarizing element, an etalon, and a second end mirror, the first end mirror and the second end mirror forming an external cavity, wherein the semiconductor gain structure, the polarizing element and the etalon are arranged in the external cavity, wherein the method comprises the steps of generating and amplifying electromagnetic laser radiation in the semiconductor gain structure, and restricting an emission of the laser to single mode operation by the polarizing element and the etalon.

The design of an external cavity semiconductor laser is ruled by a semiconductor chip containing a semiconductor gain structure and optionally a first end mirror of the cavity. The semiconductor gain structure provides amplification and gain for the electromagnetic laser radiation. Once the semiconductor gain structure and the first end mirror are part of the same semiconductor chip this arrangement is also denoted as a gain mirror. In order to enable single mode operation in the external cavity formed between the first end mirror and the second end mirror an etalon and a polarizing element are inserted into the cavity.

External cavity semiconductor lasers of the prior art, in particular optically pumped external cavity semiconductor lasers, are designed to generate and output laser radiation at a single mode. In order to allow a modulation of a wavelength of the laser radiation typically the second end mirror is mounted on a piezoelectric crystal. The piezoelectric crystal provides for an electrically controlled linear motion of the second end mirror and thus a change in the optical pathlength of the cavity. However, the wavelength modulation bandwidth provided with this design is typically limited to a range from 10 kHz to 200 kHz. This limits modulation of the laser cavity and in turn modulation limits for example locking of the laser cavity to an external reference once higher modulation frequencies are needed in the locking scheme. This severely restricts the field of application of single mode external cavity semiconductor lasers.

When compared to the prior art, it is an object of the present disclosure to provide an external cavity semiconductor laser enabling higher modulation frequencies for the wavelength of the generated laser radiation.

The above object is solved by a laser according to attached independent claim 1. To solve the object, the etalon of the laser comprises an electro-optic crystal and an electrode structure, wherein the electrode structure is arranged and configured to apply an electric field to the electro-optic crystal so that, during operation of the laser, an optical pathlength of the external cavity is variable in dependence upon the electric field applied to the electro-optic crystal.

The design according to the present disclosure allows much higher modulation frequencies than a mechanical variation of the optical pathlength of the laser radiation in the cavity. This possibility to alter the optical pathlength of the external cavity by applying an electric field to the electro-optic crystal allows to stabilize the frequency distribution of the laser radiation around a center frequency to an external reference source like a stabilized cavity, a reference laser, etc. over a much broader bandwidth. Another possible use of the electro-optic crystal is to use it as a fast phase matcher between different elements of the cavity. For example, in a design wherein the first end mirror and the semiconductor gain structure are provided by separate entities, the phase of the light field at either component could be matched by the use of the electro-optic crystal placed between the two parts. Another possible use is to match the output phases of two identical lasers, so that they can be used in a coherent beam combining, for example.

It is the basic concept of the present disclosure to provide the etalon with a combined functionality. On the one hand, the etalon according to the present disclosure contributes to the required single mode operation of the laser. On the other hand, the etalon allows to alter the optical pathlength for the laser radiation in the external cavity. According to the present disclosure, the electro-optic crystal forms part of the etalon. It is an advantage of the claimed solution that it provides a higher bandwidth for modulation of the cavity without requiring additional elements integrated into the cavity.

When compared to a conventional etalon, wherein a hollow space is formed between two reflectors, the etalon according to the present disclosure is a solid etalon. A solid etalon does not necessarily require any reflective coating and thus reduces the manufacturing complexity. Applying an electric field to the electro-optic crystal during use of the etalon modifies the optical pathlength of the etalon, tuning the frequency of the laser within the free spectral range of the external cavity.

In an embodiment the first end mirror and the semiconductor gain structure are integrated into a single semiconductor chip, i.e. a semiconductor gain mirror. The gain mirror provides two functionalities, namely the first end mirror of the laser cavity and the semiconductor gain structure as the gain medium of the laser. Various embodiments of gain mirrors are known from the prior art.

In an embodiment of the present disclosure, the semiconductor gain structure is part of a vertical surface emitting gain mirror, wherein the gain structure or gain medium and the first end mirror are integrated together, wherein the generated radiation exits the gain structure via an extended surface of the chip. In another embodiment, the semiconductor gain structure is part of an edge emitting structure, wherein the laser radiation exits the chip via an edge of the chip.

In an embodiment of the present disclosure, the semiconductor gain structure is a gain structure to be optically pumped by electromagnetic pump radiation during operation of the laser. A laser, wherein the semiconductor gain structure is optically pumped is often referred to as an optically pumped semiconductor disc laser.

It is apparent that in an embodiment wherein the semiconductor gain structure is part of a gain mirror, which gain mirror also comprises the first end mirror, the etalon is placed between the semiconductor gain structure and the second end mirror.

In an alternative embodiment, the semiconductor gain structure is a vertical surface emitting structure, wherein the semiconductor gain structure and the first end mirror are formed by separate entities, which entities are preferably distanced from each other.

In an embodiment of the present disclosure, the semiconductor gain structure is separate from the first end mirror, and the separate semiconductor gain structure is to be optically pumped by electromagnetic pump radiation during operation of the laser. A structure, wherein the separate gain of the gain structure is optically pumped is often referred to as membrane external cavity surface emitting laser.

It is apparent that in an embodiment wherein the semiconductor gain structure is formed by an entity being separate from the first end mirror, the etalon may alternatively be placed between the semiconductor gain structure and the second end mirror or between the semiconductor gain structure and the first end mirror.

According to the present disclosure, the cavity formed by the first end mirror and the second end mirror is a so-called external cavity as not the entire cavity is formed inside the semiconductor gain structure. The second end mirror could also be denoted as an external end mirror as the second end mirror is in no embodiment part of the semiconductor chip forming the gain structure.

The external cavity according to the present disclosure is a standing wave cavity requiring exactly two end mirrors, namely the first end mirror and the second end mirror. However, the shape of the external cavity is not restricted. Any number of reflectors or folding mirrors may be provided in the beam path of the laser radiation between the first end mirror and the second end mirror. For example, the external cavity could have an I-shape, a V-shape, an N-shape or an M-shape.

The polarizing element in the cavity provides a mode filtering guaranteeing single polarization operation of the laser by polarization selection. Simultaneously polarization selection is required to address the electro-optic crystal of the etalon with an appropriate polarization.

In an embodiment of the present disclosure the polarizing element is selected from a group comprising a Lyot filter, a Brewster plate, a birefringent filter, a polarizing beam splitter and a grating provided on a surface of any one of the elements in the cavity, e.g. on a surface of the semiconductor gain structure, or a combination thereof.

In an embodiment, the polarizing element is a birefringent filter positioned in the external cavity under a Brewster angle.

A material suitable as an electro-optic crystal for the etalon needs to exhibit an electro-optic response. In other terms, the material must have an non-symmetrical crystalline structure. Beneficially, the materials should have a high linear electro-optic coefficient, a low absorption coefficient at the wavelength of the laser radiation, a low thermal-optic coefficient and a low thermal extension coefficient to improve stability of the etalon under high power. Examples of crystals fulfilling at least one of these requirements are: lithium niobate, ADP, KDP, RTP, BBO or KTP.

To enhance the electro-optic effect, the polarization of the laser radiation should be linear and aligned appropriately with the crystal axis of the electro-optic crystal. The polarizing element included in the cavity forces the cavity to support only one linear polarization, which in turn enables alignment of the optical axes of the electro-optic crystal with the linear polarization of the laser mode and thus reduction of losses.

In an embodiment of the present disclosure, the geometrical thickness of the etalon between the first end facet and the second end facet and measured perpendicular to the first end facet is equal to 3 mm or less, preferably is equal to 2 mm or less. In an embodiment, the geometrical thickness of the etalon is in a range from 0.5 mm to 3 mm. Due to the enlarged interaction length of the laser radiation and the crystal, increasing the thickness improves the available modulation depth. On the other hand, increasing the thickness of the electro-optic crystal increases the absorption in the etalon, causing a higher heat load to the element and potentially leads to stability issues. Finally, the thickness of the etalon is a crucial feature for mode selection. In particular, once a large free spectral range is desired, the thickness has to be chosen towards the lower limit.

In an embodiment of the present disclosure, the etalon comprises a free spectral range equal to 10 GHz or more. In an embodiment of the present disclosure, the etalon comprises a free spectral range equal to 180 GHz or less. In an embodiment of the present disclosure, the free spectral range of the etalon is in a range from 10 GHz to 180 GHz.

In an embodiment, an optical path of the etalon between the first end facet and the second end facet consist of the material of the electro-optic crystal.

A large benefit of combining the functionalities of an electro-optic modulator and an etalon in the cavity by use of an etalon comprising an electro-optic crystal is that this combination removes the need for coating the modulator element by a dielectric antireflection coating. This means, that the same etalon can be used within the transmission band of the chosen crystal material, which for typical electro-optic crystals covers a large portion of the spectrum of typical semiconductor laser materials, from 400 nm to 2000 nm and beyond, for example.

In an alternative embodiment, the end facets of the etalon are provided by dielectric mirrors applied to the electro-optic crystal. In this embodiment, the optical path of the etalon consists of the electro-optic crystal and the two dielectric mirrors. In an embodiment, these dielectric mirrors are partially reflecting coatings increasing the finesse of the etalon. By increasing the finesse, the frequency modulation of the external cavity leads to a high degree of amplitude modulation.

In an embodiment, the single mode of the laser radiation comprises a center wavelength, wherein the second end mirror is an output coupler comprising a transmission of the laser radiation at the center wavelength. In an embodiment, the output coupler comprises a transmission of 10% or less at the center wavelength, preferably of 5% or less at the center wavelength. In an embodiment, the output coupler comprises a transmission of 0.5 % or more at the center wavelength, preferably of 1 % or more at the center wavelength. In an embodiment, the transmission of the output coupler amounts to 1% or 2%. In an embodiment of the disclosure, the transmission of the output coupler is in a range from 0.5 % to 5%.

Furthermore, in an embodiment a thickness in a direction of propagation of the laser radiation of the semiconductor gain structure is considerably short leading to a low gain of the semiconductor gain structure.

In an embodiment the gain of the semiconductor gain structure is considerably low. The low gain of the semiconductor gain structure enables low output coupling of the second end mirror. Furthermore, the low gain enables use of a low finesse etalon, i.e. e.g. uncoated etalon.

In an alternative embodiment, the second end mirror is a high reflective mirror not acting as an output coupler. In this embodiment, a nonlinear optical crystal is placed in the external cavity forming part of the beam path of the laser radiation in the cavity. In this embodiment, the laser radiation generated by the laser is not directly emitted from the cavity. Instead, converted radiation generated in the non-linear optical crystal from the laser radiation is radiated or emitted from the source formed by the laser and the non-linear optical crystal. In an embodiment, the converted radiation is emitted from the cavity through at least one of the first or the second end mirror, wherein in an embodiment the reflectivity of the first or second end mirror is lower for the converted radiation than for the laser radiation.

In an embodiment, the second end mirror is mounted on a piezo actuator, wherein the piezo actuator is arranged and configured so that, during operation of the laser, the optical path length of the laser cavity is variable dependent upon an electrical signal applied to the piezo actuator.

In an embodiment, at least a temperature of the etalon or an angle between a surface normal of the first end facet and the laser radiation is variable so that, during the operation of the laser, a center frequency of the transmission band of the etalon is varied dependent upon the temperature or the angle.

Furthermore, the above object is also solved by a laser system comprising a laser according to an embodiment as it has been described before and a pump laser, wherein during operation of the laser system the pump laser generates electromagnetic pump radiation used to optically pump the semiconductor gain structure.

The above object is also solved by a laser system comprising a laser according to an embodiment as it has been described before, a controller and a reference device. In this embodiment of the laser system, the controller is operatively coupled to the electrode structure to provide the electrode structure with an etalon correction signal during operation of the laser system, wherein the controller is operatively coupled to the reference device to receive a reference signal from the reference device during the operation of the laser system, wherein the reference signal contains information about a difference between a center wavelength of the mode of the laser radiation and a reference wavelength, and wherein the controller is configured to generate and transmit the etalon correction signal to the electrode structure such that a variation of the center wavelength of the mode of the laser radiation relatively to the reference wavelength is minimized.

According to an embodiment of the laser system the second end mirror of the laser is mounted on a piezo actuator, wherein the piezo actuator is arranged and configured so that, during operation of the laser, the optical path length of the laser cavity is variable dependent upon an electrical signal applied to the piezo actuator. In an embodiment the controller is operatively coupled to the piezo actuator in addition to the electrode structure to provide the piezo actuator with a piezo correction signal during operation of the laser system. Furthermore, the controller is configured to generate and transmit the piezo correction signal to the piezo actuator such that a variation of the center wavelength of the mode of the laser radiation relatively to the reference wavelength is minimized. In an embodiment of the disclosure the controller is configured to generate the etalon correction signal to minimize the variation of the center wavelength of the mode of the laser radiation relatively to the reference wavelength occurring in a first frequency range and to generate the piezo correction signal to minimize the variation of the center wavelength of the mode of the laser radiation relatively to the reference wavelength occurring in a second frequency range, wherein the first frequency range only comprises frequencies being higher than those frequencies contains in the second frequency range.

In an embodiment, this laser system comprises a pump source for electromagnetic pump radiation, wherein the pump source is arranged and configured so that during the operation of the laser system the pump radiation pumps the semiconductor gain structure.

The above object is also solved by a method for generating and emitting electromagnetic laser radiation in a laser according to the independent claim dedicated to the method. Therefore in the above method, the etalon comprises an electro-optic crystal, wherein the method further comprises the steps of: applying an electric field to the electro-optic crystal, and varying an optical pathlength of the external cavity varying the electric field.

Where aspects of the disclosure have been described before in relation to the laser and the laser system, these aspects also apply to the corresponding method for generating and emitting electromagnetic laser radiation in a laser and vice versa. To the extent that the method is carried out with a laser according to the present disclosure, the laser has the appropriate means for carrying out the method. In particular, embodiments of the laser are suitable for carrying out embodiments of the method described herein.

Further advantages, features and applications of the present disclosure will become apparent from the following description of embodiments and the corresponding figures attached. The foregoing as well as the following detailed description of the embodiments will be better understood when read in conjunction with the appendant drawings. It should be understood that the embodiments depicted are not limited to the precise arrangements and instrumentalities shown. Identical elements in the figures have been denoted by identical reference signs.
- Figure 1: is a schematic top view of a laser according to a first embodiment.
- Figure 2: is a schematic top view of a laser according to a second embodiment.
- Figure 3: is a schematic top view of a laser according to a third embodiment.

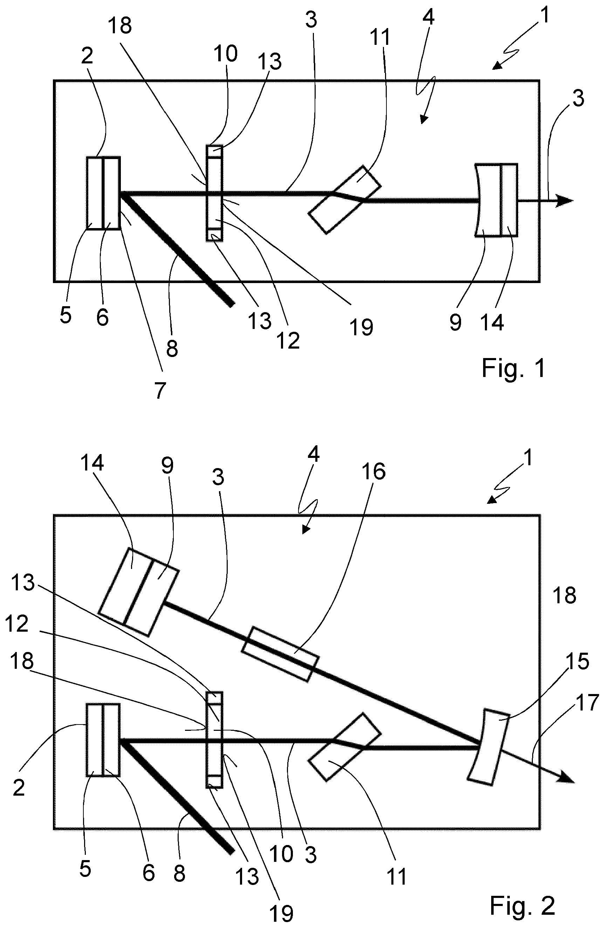

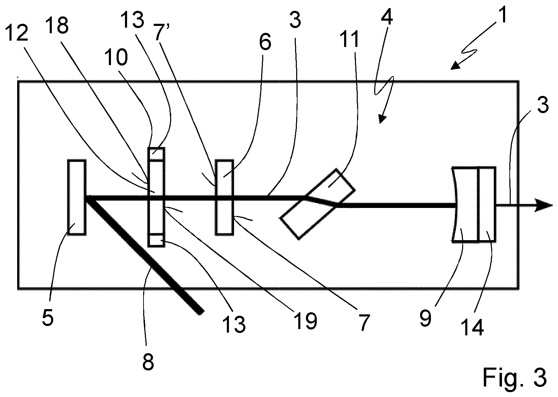

The embodiments of figures 1 and 2 represent lasers 1 whose designs could be described as Optically Pumped Vertical-Cavity-Surface-Emitting Lasers 1 (OP-VECSEL). The embodiment of figure 3 represents a laser 1 whose design could be described as a Membrane External Cavity Semiconductor Laser (MECSEL) laser 1.

In the embodiments of figures 1 and 2 emission and amplification of the laser radiation 3 is provided by a gain mirror 2 combining two functionalities, namely providing emission and amplification of the laser radiation 3 and reflection of the laser radiation in the resonator or cavity 4. Thus, in the embodiments of figures 1 and 2 the gain mirror includes a first end mirror 5 and a semiconductor gain structure 6.

In the embodiments of figures 1 and 2 the emission of the laser radiation 3 from the semiconductor gain structure 6 is provided through a surface 7 of the gain structure 6. This concept is described as VECSEL in contrast to alternative concepts, where emission occurs through an edge of the gain structure, i.e. in a direction perpendicular to the growth direction of the chip forming the gain structure 6.

In the embodiment of figure 3 the semiconductor gain structure 6 and the first end mirror 5 are not integrated into a single gain mirror, but are provided as separate elements being spaced from each other. In this design the emission of the laser radiation 3 from the gain structure 6 is provided through both opposing surfaces 7, 7' of the semiconductor gain structure 6. This concept is referred to as MECSEL.

In all embodiments of figures 1, 2 and 3, the semiconductor gain structure 6 provides part of an OP-VECSEL, i.e. during operation of the laser 1 optical pump radiation 8 from a pump source is incident on the semiconductor gain structure 6.

In the external cavity design there are cavity components not being integral with the semiconductor gain structure 6. For example, in all embodiments of figures 1 to 3 the second end mirror 9 is provided externally, i.e. separately from the semiconductor gain structure 6. Thus, the cavity provided is denoted an external cavity 4. An external cavity 4 allows to provide elements in the cavity which cannot or can only with exceptional effort be implemented in a single chip. In the embodiments depicted, an etalon 10 and a birefringent filter 11 as the polarizing element are placed in the external cavity 4 in order to provide single mode operation of the respective laser 1 and modulation capability of the laser at high modulation frequencies.

According to the present disclosure, the etalon 10 in each of the cavities 4 consists of an electro-optic crystal 12 and a pair of electrodes 13 as an electrode structure in the sense of the present disclosure. By applying a voltage across the electrodes 13 and thus providing an electric field penetrating the electro-optic crystal 12 during operation of the laser 1, the optical pathlength of the external cavity 4 can be varied depending upon the electric field applied. By modulating the electrostatic field applied between the electrodes 13, the wavelength of the laser radiation can be modulated. In order to allow for an optimized wavelength tuning of the cavities 4, the second end mirror 9 is mounted on a piezo actuator 14.

The etalon 10 comprises a first end facet 18 and a second end facet 19. The end facets 18, 19 are formed by a boundary surface of the electro-optic crystal 12 and the surrounding air/gas. I.e. the etalon 10 does not have any reflective coatings on the surfaces of the electro-optic crystal 12.

In the embodiment of figure 1, the laser 1 has an overall linear design also denoted as an I-shape design. The second end mirror 9 in this embodiment has a considerable low transmission of 2 % for the laser radiation 3 and thus only part of the laser radiation 3 is coupled out of the cavity 4 to be used in an optical set up. Thus, in this embodiment, the second end mirror 9 is an output coupler.

In contrast, the cavity design of the cavity 4 of the laser 1 of figure 2 can be described as a V-shape. In order to provide the V-shape, the cavity 4 of figure 2 further comprises a folding mirror 15.

The cavity 4 of the laser 1 of figure 2 is designed to confine the generated amplified laser radiation 3 in the cavity 4 entirely. Only a very small fraction of the laser radiation 3 is coupled out of the cavity 4 on purpose for referencing. The second end mirror 9 like the first end mirror 5 is a high reflector providing no output of the laser radiation 3 except for some reference radiation. Instead, in the external cavity 4 a non-linear optical crystal 16 is provided, which generates second harmonic light 17, i.e. electromagnetic radiation having twice the frequency of the laser radiation 3 generated and amplified in the semiconductor gain structure 6. The second harmonic light 17 generated in the non-linear optical crystal 16 depending on the direction of travel of the generating laser radiation 3 is emitted to both directions of the non-linear optical crystal 16. In order to obtain as much output of the second harmonic radiation as possible, the second end mirror 9 is not only highly reflective for the laser radiation 3, but also for the second harmonic radiation 17. The folding mirror 15 in turn is provided such that it is highly transmissive for the second harmonic radiation 17. Consequently, the second harmonic radiation 17 is coupled out of the cavity 4 and can be used in a further optical setup.

It is noted that features described in relation to one embodiment can also be used in other embodiments clearly understandable by a person skilled in the art.

While the disclosure has been described in detail and with reference to the figures, this description is only an example and is not considered to restrict the scope of protection as it is defined by the claims.

In the claims, the word "comprising" does not exclude other elements or steps and the undefined article "a" does not exclude a plurality. The mere fact that some features have been claimed in different claims does not exclude their combination. Reference numbers in the claims are not considered to restrict the scope of protection.

### Reference signs

- 1: laser
- 2: gain mirror
- 3: laser radiation
- 4: cavity
- 5: first end mirror
- 6: semiconductor gain structure
- 7: surface of the semiconductor gain structure 6 facing toward second end mirror 9
- 7': surface of the semiconductor gain structure 6 facing toward first end mirror 5
- 8: pump radiation
- 9: second end mirror
- 10: etalon
- 11: birefringent filter
- 12: electro-optic crystal
- 13: electrode
- 14: piezo actuator
- 15: folding mirror
- 16: non-linear optical crystal
- 17: second harmonic generation
- 18: first end facet
- 19: second end facet

## Claims

1. A laser (1) comprising
a first end mirror (5),
a semiconductor gain structure (6),
wherein during an operation of the laser (1) the semiconductor gain structure (6) generates and amplifies electromagnetic laser radiation (3),
a polarizing element (11),
an etalon (10),
wherein the etalon (10) comprises a first end facet (18) and a second end facet (19), which first end facet (18) and second end facet (19) are parallel to each other, and
a second end mirror (9),
wherein the first end mirror (5) and the second end mirror (9) form an external cavity (4),
wherein the semiconductor gain structure (6), the polarizing element (11) and the etalon (10) are arranged in the external cavity (4), and
wherein the polarizing element (11) and the etalon (10) are configured so that, during the operation of the laser (1), the laser (1) generates the laser radiation (3) at a single mode,
**characterized in that**
the etalon (10) comprises an electro-optic crystal (12) and an electrode structure (13),
wherein the electrode structure (13) is arranged and configured to apply an electric field to the electro-optic crystal (12) so that, during operation of the laser (1), an optical pathlength of the external cavity (4) is variable in dependence upon the electric field applied to the electro-optic crystal (12).

2. The laser (1) according to the previous claim, wherein a geometrical thickness of the etalon (10) between the first end facet (18) and a second end facet (19) and measured perpendicular to the first end facet (18) is equal to 3 mm or less, preferably is equal to 2 mm or less.

3. The laser (1) according to anyone of the previous claims, wherein the etalon (10) comprises a free spectral range equal to 10 GHz or more.

4. The laser (1) according to anyone of the previous claims, wherein an optical path of the etalon (10) between the first end facet (18) and the second end facet (19) consists of the electro-optic crystal (12).

5. The laser (1) according to anyone of the previous claims, wherein the single mode of the laser radiation (3) comprises a centre wavelength, and wherein the second end mirror (9) is an output coupler comprising a transmission of 10 % or less at the centre wavelength, preferably of 5 % or less at the centre wavelength.

6. The laser (1) according to anyone of the previous claims, wherein the second end mirror (9) is mounted on a piezo actuator (14), and wherein the piezo actuator (14) is arranged and configured so that, during the operation of the laser (1), the optical pathlength of the laser (1) is variable in dependence upon an electrical signal applied to the piezo actuator (14).

7. The laser (1) according to anyone of the previous claims, wherein at least a temperature of the etalon (10) or an angle between a surface normal of the first end facet (18) and the laser radiation (3) is variable so that, during the operation of the laser (1), a centre frequency of the transmission band of the etalon is variable in dependence upon the temperature or the angle.

8. The laser (1) according to anyone of the previous claims, wherein the semiconductor gain structure (6) is an optically pumped semiconductor gain structure.

9. The laser (1) according to anyone of the previous claims, wherein the polarizing element (11) is a birefringent filter.

10. A laser system comprising a laser (1) according to anyone of the previous claims, a controller and a reference device,
wherein the controller is operatively coupled to the electrode structure (13) to provide the electrode structure (13) with a correction signal during operation of the laser system,
wherein the controller is operatively coupled to the reference device to receive a reference signal from the reference device during the operation of the laser system, wherein the reference signal contains information about a difference between a centre wavelength of the mode of the laser radiation (3) and a reference wavelength, and
wherein the controller is configured to generate and transmit the correction signal to the electrode structure (13) such that a variation of the centre wavelength of the mode of the laser radiation (3) relatively to the reference wavelength is minimized.

11. The laser system according to the previous claim, wherein the laser system comprises a pump source for electromagnetic pump radiation (8), wherein the pump source is arranged and configured so that, during the operation of the laser system the pump radiation (8) pumps the semiconductor gain structure (6).

12. A method for generating and emitting electromagnetic laser radiation (3) in a laser,
wherein the laser comprises a first end mirror (5), a semiconductor gain structure (6), a polarizing element (11), an etalon (10), and a second end mirror (9), the first end mirror (5) and the second end mirror (9) forming an external cavity (4),
wherein the semiconductor gain structure (6), the polarizing element (11) and the etalon (10) are arranged in the external cavity (4),
wherein the method comprises the steps of
generating and amplifying electromagnetic laser radiation (3) in the semiconductor gain structure (6), and
restricting an emission of the laser (1) to single mode operation by the polarizing element (11) and the etalon (10),
**characterized in that**
the etalon (10) comprises an electro-optic crystal (12),
wherein the method further comprises the steps of
applying an electric field to the electro-optic crystal (12), and
varying an optical pathlength of the external cavity (4) by varying the electric field.
